# EUROPEAN PATENT APPLICATION

(11) **EP 3 772 717 A1**
(43) Date of publication of application: **10.02.2021**
(21) Application number: 20189319.5
(22) Date of filing: 04.08.2020
(51) Int. Cl.: G06Q 30/06

(54) **ORDER ISSUING AND RECEIVING MATCHING SYSTEM, ORDER ISSUING AND RECEIVING MATCHING METHOD, AND NON-TRANSITORY COMPUTER READABLE MEDIA**

(30) Priority: 08.08.2019 JP 2019146431
(71) Applicant: JTEKT CORPORATION, Chuo-ku, Osaka-shi, Osaka 542-8502 (JP)
(72) Inventor: KAMIDE, Takeshi, Osaka-shi, Osaka 542-8502 (JP)
(74) Representative: TBK

(57) **Abstract**

An order issuing and receiving matching system configured to mediate an orderer and an order receiver includes an order issuing information reception unit configured to receive order issuing information including graphic information on an ordered product from the orderer; an order issuing information provision unit configured to provide the order issuing information to order receiving candidates; a quotation reception unit configured to receive a quotation from each of the order receiving candidates; a quotation provision unit configured to provide the quotation to the orderer; and a form information acquisition unit configured to acquire form information representing a form of the ordered product from one or more of the order receiving candidates.

## Description

### Background

### Field of the Invention

The present invention relates to an order issuing and receiving matching system and method that mediate an orderer and an order receiver and a computer-readable medium storing computer-executable instructions that, when executed by the processor of a computer, control the computer to perform steps of the order issuing and receiving matching method.

### Related Art

A related art matching service described in JP2018-180671A mediates an orderer who issues an order and an order receiver who receives the order. In the matching service described in JP2018-180671A, the orderer sends information on an case to be ordered to a computer of a coordinator who is in charge of order receiving candidate companies via the Internet, and the coordinator introduces the case to an appropriate order receiving candidate company. The order receiving candidate company that has been determined to enter the case accesses a company selection system and enter the case. The orderer views information on the entered order receiving candidate company. When the orderer wants to interview with the entered order receiving candidate company, the orderer applies for an interview by a phone, an e-mail or the like, and pays an introduction fee to an operator of the matching service.

When selecting an order issuing destination, the orderer provides a drawing or an image of a product to be ordered for order receiving candidates, and often uses a quotation presented by each order receiving candidate as a selection criterion. Each order receiving candidate calculates the quotation by extracting, for example, the number of processing points or processing contents based on the drawing or the image of the ordered product, and this work requires high expertise and a long time. Therefore, the more complicated a form of the ordered product is, the longer time the orderer may have to wait until obtaining the quotation from providing the drawing or the image of the product for the order receiving candidates. If a submission period of the quotation is set to be short, there may be the order receiving candidate who cannot submit the quotation by a deadline.

To address this, for example, the operator of the matching service may extract the number of processing points or the processing contents of the ordered product and provide the extracted information to the order receiving candidates. This may reduce a work load of each order receiving candidate and allow the order receiving candidate to submit the quotation early. In addition, this may allow the operator of the matching service to statistically manage the information extracted by the operator of the matching service together with the quotation presented by the order receiving candidate and use the information and quotation for, for example, evaluation of each order receiving candidate and analysis of a field of specialty of each order receiving candidate.

However, the operator of the matching service is not always rich in knowledge and know-how regarding product processing and the like, and may have difficulty in representing the form of the ordered product (the extracted information) by a numerical value or a character string.

### Summary

Embodiments of the present invention provides an order issuing and receiving matching system and method that allows an operator of a matching service to easily obtain information representing a form of an ordered product by using a numerical value or a character string.

According to an embodiment of the present invention, an order issuing and receiving matching system configured to mediate an orderer and an order receiver includes an order issuing information reception unit configured to receive order issuing information including graphic information on an ordered product from the orderer; an order issuing information provision unit configured to provide the order issuing information to order receiving candidates; a quotation reception unit configured to receive a quotation from each of the order receiving candidates; a quotation provision unit configured to provide the quotation to the orderer; and a form information acquisition unit configured to acquire form information representing a form of the ordered product from one or more of the order receiving candidates.

According to another embodiment of the present invention, an order issuing and receiving matching method configured to mediate an orderer and an order receiver includes computer-implemented steps of: receiving order issuing information including graphic information on an ordered product from the orderer; providing the order issuing information for order receiving candidates; receiving a quotation from each of the order receiving candidates; providing the quotation to the orderer; and acquiring form information representing a form of the ordered product from one or more of the order receiving candidates.

According to another embodiment of the present invention, a computer-readable medium storing computer-executable instructions that, when executed by the processor of a computer, control the computer to perform steps of the order issuing and receiving matching method.

### Brief Description of the Drawings

Fig. 1 is a block diagram illustrating a schematic configuration of an order issuing and receiving matching system according to a first embodiment of the present invention;
Fig. 2 is a diagram showing an example of graphic information of an ordered product;
Fig. 3 is a perspective view of the ordered product shown in Fig. 2;
Fig. 4 is a plan view showing a plate member in a process of processing the ordered product shown in Fig. 2;
Fig. 5 is a table illustrating contents of form information on the ordered product shown in Fig. 2; and
Fig. 6 is a block diagram illustrating a schematic configuration of an order issuing and receiving matching system according to a second embodiment of the present invention.

### Detailed Description of the Exemplary Embodiments

### [First embodiment]

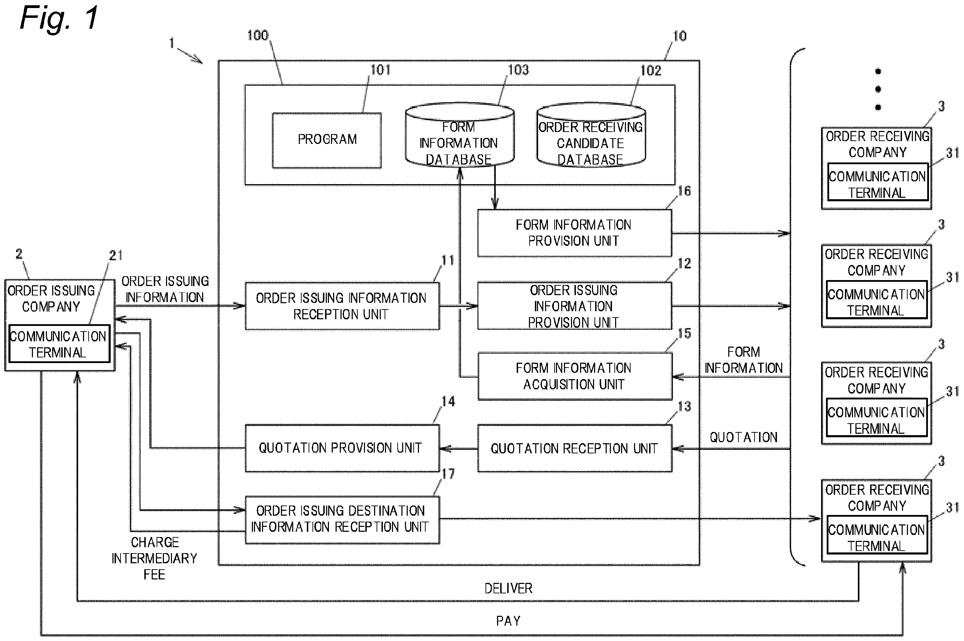

A first embodiment of the present invention will be described with reference to Figs. 1 to 5. The embodiments described below is given as an appropriate example for carrying out the present invention and various preferable technical matters are specifically exemplified. However, the technical scope of the present invention is not limited to the specific embodiments.

Fig. 1 is a block diagram illustrating a schematic configuration of an order issuing and receiving matching system according to the first embodiment of the present invention. An order issuing and receiving matching system 1 is a system that matches an orderer who issues an order with an order receiver who receives the order. The order issuing and receiving matching system 1 includes a matching server 10 connectable to a public communication network such as the Internet.

Fig. 1 shows an order issuing company 2 as an orderer and order receiving companies 3 as order receiving candidates that can be order receivers to receive the order. A communication terminal 21 of the order issuing company 2 and communication terminals 31 of the order receiving companies 3 are capable of communicating with the matching server 10 via the public communication network. Although only one order issuing company 2 is shown in Fig. 1, the matching server 10 is capable of handling several order issuing cases from several orderers.

In the present embodiment, a case where the order issuing company 2 and the order receiving companies 3 are corporations will be described. However, the orderer and the order receiving candidates may be individuals, or may be organizations or the like that are not corporations. The communication terminal 21 and the communication terminals 31 are, for example, information processing devices such as personal computers or smartphones, but are not limited thereto, and may be, for example, facsimiles. When the communication terminal 21 and the communication terminals 31 are the facsimiles, the matching server 10 communicates with the communication terminal 21 and the communication terminals 31 through a telephone line serving as the public communication network.

The matching server 10 includes: an order issuing information reception unit 11 that receives order issuing information from the order issuing company 2, an order issuing information provision unit 12 that provides the order issuing information for pre-registered order receiving companies 3, a quotation reception unit 13 that receives a quotation from each of the order receiving companies 3, a quotation provision unit 14 that provides the order issuing company 2 with the quotation received by the quotation reception unit 13, a form information acquisition unit 15 that acquires form information representing a form of an ordered product by using a numerical value or a character string from the order receiving company 3, a form information provision unit 16 that provides the form information acquired by the form information acquisition unit 15 for the order receiving company 3 that has not submitted the quotation among the order receiving companies 3, and the order issuing destination information reception unit 17 that receives information on an order issuing destination when the order issuing company 2 determines the order issuing destination.

The order issuing information reception unit 11, the order issuing information provision unit 12, the quotation reception unit 13, the quotation provision unit 14, the form information acquisition unit 15, the form information provision unit 16 and the order issuing destination information reception unit 17 are implemented by, for example, a microprocessor of the matching server 10 executing a program 101 stored in a storage device 100 such as a hard disk. The program 101 may be stored on and provided by a computer readable non-transitory media. Computer-readable non-transitory media include, for example, optical storage media such as Compact Disc ROM (CD-ROM), magnetic storage media such as Hard Disk Drive (HDD), and semiconductor storage media such as flash memory. The program 101 may also be provided by downloading via a network.

The order issuing information received by the order issuing information reception unit 11 includes information such as a delivery date and a delivery destination, as well as graphic information on the ordered product to be ordered. The graphic information is, for example, a two-dimensional drawing showing a shape or a structure of the ordered product; a photograph, an illustration or a moving image of the ordered product; or two-dimensional or three-dimensional CAD data of the ordered product.

The storage device 100 stores, in addition to the program 101, an order receiving candidate database 102 in which contact information on order receiving companies 3 is registered, and a form information database 103 in which the form information acquired by the form information acquisition unit 15 is registered in association with the graphic information.

The order issuing information reception unit 11 receives the order issuing information transmitted from the order issuing company 2 via the public communication network, and the order issuing information provision unit 12 transmits the order issuing information to the order receiving companies 3 registered in the order receiving candidate database 102 via the public communication network. The quotation reception unit 13 receives the quotation from each of the order receiving companies 3 via the public communication network. When the quotation reception unit 13 receives the quotation submitted from the order receiving company 3, the quotation provision unit 14 transmits information on the quotation to the order issuing company 2 via the public communication network.

The order issuing destination information reception unit 17 receives the information on the order issuing destination from the order issuing company 2, and notifies the order receiving company 3 selected as the order issuing destination. Upon receiving the notification, the order receiving company 3 delivers the ordered product to the order issuing company 2, and the order issuing company 2 pays a consideration thereof. The order issuing destination information reception unit 17 transmits charge information on an intermediary fee to the order issuing company 2.

The form information acquisition unit 15 acquires the form information from the order receiving company 3 via the public communication network together with, for example, the quotation. The form information acquisition unit 15 registers the acquired form information in the form information database 103 as a record in association with the graphic information included in the order issuing information. The registration is performed each time the form information is acquired from the order receiving company 3, and several records are registered in the form information database 103 when the form information is acquired from the several order receiving companies 3 for one order issuing case.

The form information provision unit 16 provides the form information registered in the form information database 103 for the order receiving company 3 via the public communication network, for example, in response to an inquiry from the order receiving company 3. When performing such pull-type information provision, the form information provision unit 16 may notifies each order receiving company 3 that the form information is registered in the form information database 103, for example, by sending the e-mail. Further, when performing the pull-type information provision, the form information provision unit 16 may provide form information for the receiving company 3 having the inquiry based on a mode value or an average value of several pieces of the form information, which may be acquired from the several order receiving companies 3.

However, the present invention is not limited to such pull-type information provision, the form information provision unit 16 may perform push-type information provision in which the form information provision unit 16 automatically transmits the form information acquired from any one of the order receiving companies 3 to other order receiving companies 3 by, for example, an e-mail. When performing the push-type information provision, the form information provision unit 16 transmits the form information to other order receiving companies 3 each time the form information acquisition unit 15 acquires the form information from the order receiving company 3, for example.

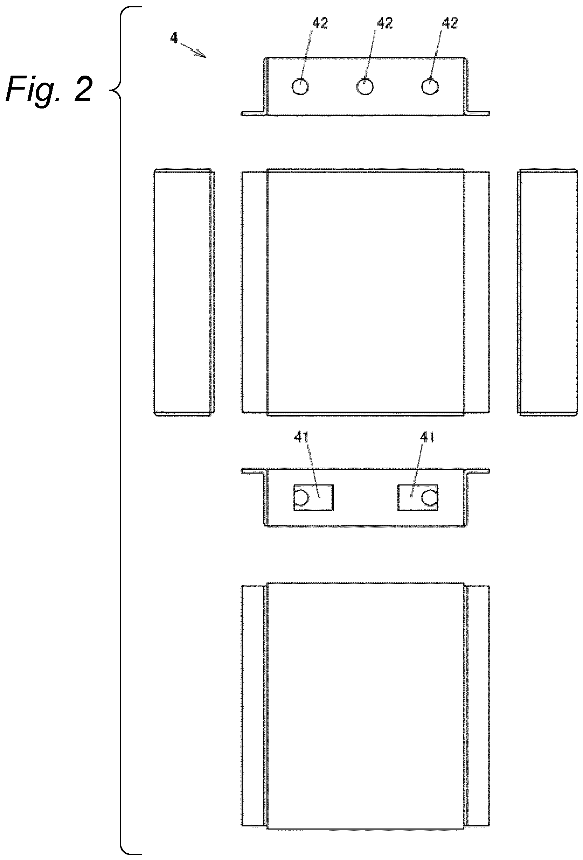

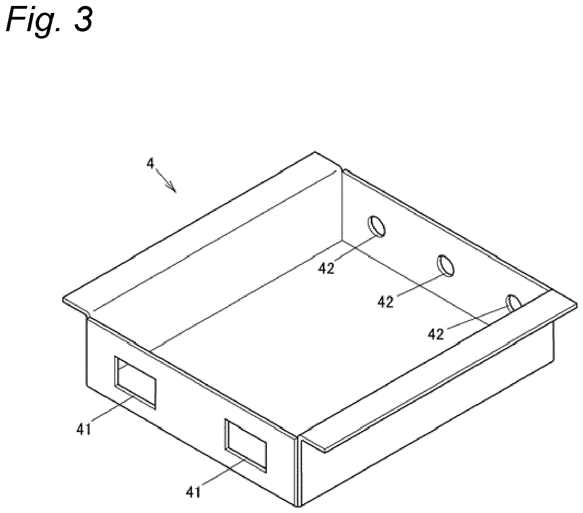

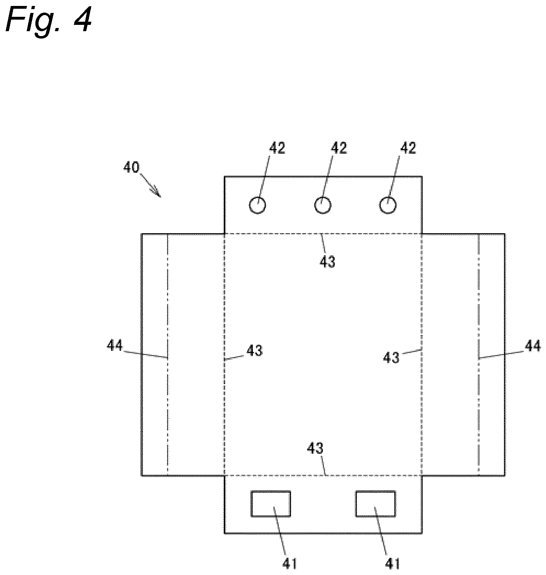

Fig. 2 is a view (a hexagonal view) showing graphic information on an example of an ordered product 4. Fig. 3 is a perspective view of the ordered product 4 shown in Fig. 2, and Fig. 4 is a plan view showing a plate member 40 in a process of processing the ordered product 4 shown in Fig. 2. In Fig. 2, illustration of dimension lines of parts and numerical values indicating dimensions, and illustration of a plate thickness and a material are omitted.

In this example, the ordered product 4 is a box-shaped product obtained by drilling and bending the plate member 40 obtained by punching a steel plate. A plurality of square holes 41 and a plurality of round holes 42 are provided in the ordered product 4. In Fig. 4, a valley fold line 43 for bending a valley fold is indicated by a broken line, and a mountain fold line 44 for bending a mountain fold is indicated by a two-dot chain line.

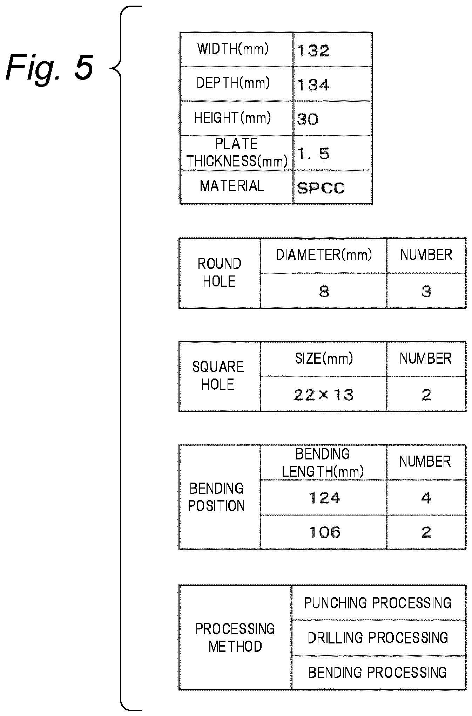

Fig. 5 is a table illustrating an example of contents of form information of the ordered product 4. The form information represents a form of the ordered product 4 by using a numerical value or a character string that can be recognized by a person. A dimension and a number are registered as numerical data, and the character string of each of a material and a processing method is registered as text data, in the form information database 103. The form information is extracted by a person in charge in the order receiving company 3 from graphic information of the ordered product 4 in order to create an own quotation.

The person in charge in the order receiving company 3 creates the quotation by inputting the extracted form information into, for example, an input box of a dialog displayed on a display of a personal computer that executes a program for quotation creation. The person in charge may submit only the created quotation to the matching server 10, and may submit to the matching server 10 the form information that is the basis of the quotation together with the quotation. The submitted form information is acquired by the form information acquisition unit 15 and registered in the form information database 103, and is provided for other order receiving companies 3 by the form information provision unit 16. Other order receiving companies 3 can create the quotation by using the provided form information.

An operator of the order issuing and receiving matching system 1 may give some incentive (motivation) to the order receiving companies 3 in order to prompt submission of the form information. Examples of the incentive includes paying a part of the intermediary fee as a reward to the order receiving company 3 that has submitted the form information, and providing the order issuing information on next and subsequent order issuing cases from the order issuing company 2 with a time difference earlier than other order receiving companies 3. When the order receiving company 3 that has submitted the form information is determined as the order issuing destination, a system of discounting the intermediary fee charged to the order issuing company 2 may be adopted so that the order receiving company 3 can easily receive the issued order.

According to the first embodiment of the present invention described above, the order issuing and receiving matching system 1 allows the operator of the same to acquire the form information from the order receiving company 3 and register the received form information in the form information database 103 without creating the form information by analyzing the graphic information by himself or herself. Then, the order issuing and receiving matching system 1 provides the form information registered in the form information database 103 for other order receiving companies 3, providing a plurality of pieces of quotation information for the order issuing company 2 early.

In addition to the drawing as shown in Fig. 2, the graphic information may be an external view or a photograph as shown in Fig. 3 as long as the dimensions and the like of the parts can be grasped.

### [Second embodiment]

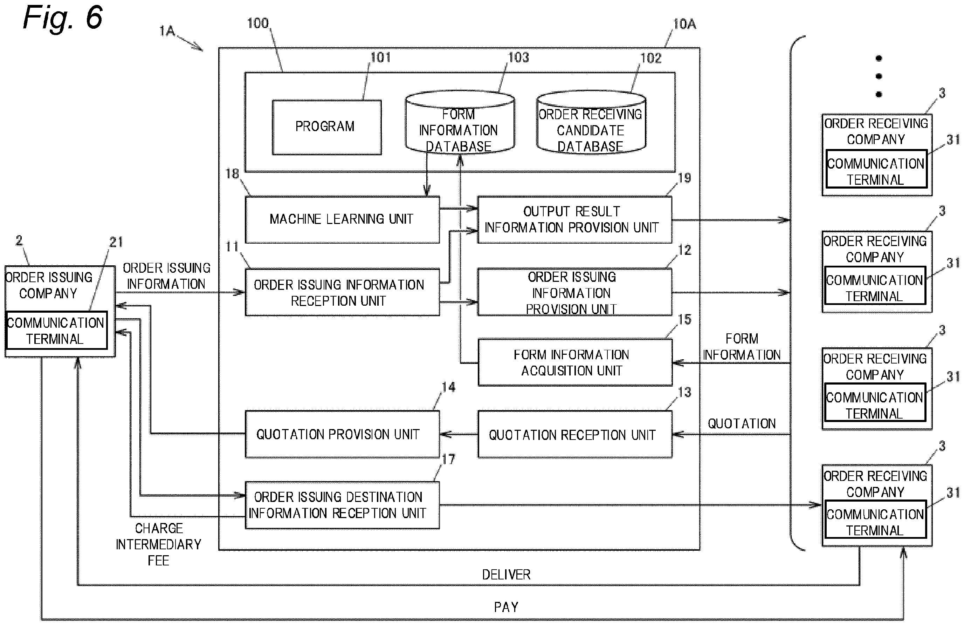

Next, a second embodiment of the present invention will be described with reference to Fig. 6.

Fig. 6 is a block diagram illustrating a schematic configuration of an order issuing and receiving matching system 1A according to the second embodiment of the present invention. In the order issuing and receiving matching system 1A shown in Fig. 6, the same components as those of the order issuing and receiving matching system 1 according to the first embodiment described with reference to Fig. 1 are denoted by the same reference numerals, and repetitive description thereof will be omitted.

A matching server 10A according to the present embodiment includes, in addition to the order issuing information reception unit 11, the order issuing information provision unit 12, the quotation reception unit 13, the quotation provision unit 14, the form information acquisition unit 15 and the order issuing destination information reception unit 17, a machine learning unit 18 that generates a learning model that derives form information from graphic information included in order issuing information, and an output result information provision unit 19 that provides the order receiving companies 3 with output result information obtained by applying the graphic information acquired by the order issuing information reception unit 11 to the learning model.

As in the first embodiment, the form information acquired by the form information acquisition unit 15 is registered in the form information database 103 in association with the graphic information. After a large number of records are accumulated in the form information database 103, the machine learning unit 18 performs supervised learning by using the form information registered in the form information database 103 as teacher data. Here, the supervised learning refers to identifying or predicting what kind of output pattern (here, the form information) the data will be, based on given input data (here, the graphic information).

When the order issuing information reception unit 11 receives the order issuing information, the output result information provision unit 19 uses the learning model generated by the machine learning unit 18 to input the graphic information included in the order issuing information and output the output result information. The output result information is provided to the order receiving companies 3 via a public communication network.

Similar to the form information acquired from the order receiving company 3 by the form information acquisition unit 15, the output result information represents a form of an ordered product by using a numerical value or a character string that can be recognized by a person. Each order receiving company 3 can easily create a quotation by using the provided output result information.

According to the second embodiment of the present invention described above, the order issuing and receiving matching system 1A allows an operator of the same to acquire the form information from the order receiving company 3 and register the received form information in the form information database 103. Then, the order issuing and receiving matching system 1A utilizes the information registered in the form information database 103 as big data to perform machine learning and automatically obtains and provides the output result information for the order receiving companies 3, providing a plurality of pieces of quotation information for the order issuing company 2 early.

The present invention has been described above on the basis of the first embodiment and the second embodiment. However, these embodiments do not limit the invention according to the claims. It should also be noted that not all combinations of the features described in the embodiments are essential to the means for solving the problem of the invention.

The present invention can be appropriately modified and carried out by omitting a part of the configuration or adding or replacing the configuration without departing from the spirit of the present invention. It is also possible to carry out the first embodiment and the second embodiment in combination. Further, the order issuing and receiving matching system according to the present invention is not limited to order issuing and receiving of an object, but can be applied to order issuing and receiving of various services such as remodeling of a building or a structure, dispatch of human resource, moving, purchase of a used car, or provision of travel or accommodation.

An order issuing and receiving matching system configured to mediate an orderer and an order receiver includes an order issuing information reception unit configured to receive order issuing information including graphic information on an ordered product from the orderer; an order issuing information provision unit configured to provide the order issuing information to order receiving candidates; a quotation reception unit configured to receive a quotation from each of the order receiving candidates; a quotation provision unit configured to provide the quotation to the orderer; and a form information acquisition unit configured to acquire form information representing a form of the ordered product from one or more of the order receiving candidates.

## Claims

1. An order issuing and receiving matching system configured to mediate an orderer and an order receiver, comprising:
an order issuing information reception unit configured to receive order issuing information including graphic information on an ordered product from the orderer;
an order issuing information provision unit configured to provide the order issuing information to order receiving candidates;
a quotation reception unit configured to receive a quotation from each of the order receiving candidates;
a quotation provision unit configured to provide the quotation to the orderer; and
a form information acquisition unit configured to acquire form information representing a form of the ordered product from one or more of the order receiving candidates.

2. The order issuing and receiving matching system according to claim 1, further comprising:
a form information provision unit configured to provide the form information on the ordered product for at least a part of the order receiving candidates by using the form information acquired by the form information acquisition unit.

3. The order issuing and receiving matching system according to claim 2, wherein the form information provision unit is configured to provide the form information on the ordered product acquired by the form information acquisition unit for an order receiving candidate that has not submitted quotation among the order receiving candidates.

4. The order issuing and receiving matching system according to claim 2, wherein the form information provision unit includes:
a form information database storing the form information acquired by the form information acquisition unit in association with the graphic information;
a machine learning unit configured to generate a learning model that derives the form information from the graphic information with reference to the form information database; and
an output result information provision unit configured to provide the order receiving candidates with output result information, as the form information on the ordered product, obtained by applying the graphic information on the ordered product acquired by the order issuing information reception unit to the learning model.

5. An order issuing and receiving matching method configured to mediate an orderer and an order receiver, the method comprising computer-implemented steps of:
receiving order issuing information including graphic information on an ordered product from the orderer;
providing the order issuing information for order receiving candidates;
receiving a quotation from each of the order receiving candidates;
providing the quotation to the orderer; and
acquiring form information representing a form of the ordered product from one or more of the order receiving candidates.

6. The order issuing and receiving matching method according to claim 5, further comprising computer implemented step of: providing the form information on the ordered product for at least a part of the order receiving candidates by using the acquired form information.

7. The order issuing and receiving matching method according to claim 6, wherein the step of providing the form information on the ordered product for at least a part of the order receiving candidates includes:
providing the acquired form information on the ordered product for an order receiving candidate that has not submitted quotation among the order receiving candidates.

8. The order issuing and receiving matching method according to claim 6, wherein the step of providing the form information on the ordered product for at least a part of the order receiving candidates includes:
obtaining output result information by inputting the graphic information on the ordered product to a learning model that is generated by using the form information and the graphic information as teacher data and outputs the form information for the inputted graphic information; and
providing the order receiving candidates with the obtained output result information as the form information on the ordered product.

9. A computer-readable medium storing computer-executable instructions that, when executed by the processor of a computer, control the computer to perform the order issuing and receiving matching method according to any one of claims 5 to 8.
